# EUROPEAN PATENT APPLICATION

(11) **EP 3 822 327 A1**
(43) Date of publication of application: **19.05.2021**
(21) Application number: 20200253.1
(22) Date of filing: 06.10.2020
(51) Int. Cl.: C09G 1/02, C09G 1/18

(54) **POLISHING SLURRY AND METHOD OF MANUFACTURING SEMICONDUCTOR DEVICE**

(30) Priority: 15.11.2019 KR 20190147029
(71) Applicant: Samsung Electronics Co., Ltd., Gyeonggi-do 16677 (KR)
(72) Inventor: JUNG, Moon Il, Gyeonggi-do (KR); KIM, Do Yoon, Gyeonggi-do (KR); TAKAI, Kenji, Gyeonggi-do (KR); MOON, Deuk Kyu, Seoul (KR); YOON, Min Hee, Gyeonggi-do (KR)
(74) Representative: Elkington and Fife LLP

(57) **Abstract**

A polishing slurry including a fullerene derivative and at least one compound having at least one positively-charged functional group, and a method of manufacturing a semiconductor device using the polishing slurry.

## Description

### FIELD OF THE INVENTION

A polishing slurry and a method for manufacturing a semiconductor device are disclosed.

### BACKGROUND OF THE INVENTION

Recently, according to the miniaturization of electronic devices and consequent miniaturization of integrated circuits, various methods of forming microstructures such as metal wires having a width of several nanometers or narrow trench isolation are of interest and have been studied.

In the forming of the microstructures, a polishing process may be performed to create a flat surface of the microstructures. One example of the polishing process is a chemical mechanical polishing (CMP). Chemical mechanical polishing is a process that includes providing polishing slurry including abrasives between a surface of a semiconductor substrate to be polished and a polishing pad, and contacting the semiconductor substrate with the polishing pad to planarize the surface of the substrate.

### SUMMARY OF THE INVENTION

Polishing slurries, including conventional abrasive particles having tens of nanometers in particle size, such as silica used to form microstructures, may cause damage and shape deformation of fine pitch structures, e.g., fine pitch structures of semiconductor structures.

An embodiment provides a polishing slurry capable of improving polishing performance while reducing damage and deformation of a fine pitch structure of a semiconductor device.

Another embodiment provides a method of manufacturing a semiconductor device using the polishing slurry.

According to an embodiment, a polishing slurry includes a fullerene derivative, and at least one compound having at least one positively-charged functional group.

The fullerene derivative may have at least one negatively-charged functional group.

The negatively-charged functional group may include at least one of a hydroxy group, a carbonyl group, a carboxylate group, a sulfonate group, a sulfate group, a sulfhydryl group, and a phosphate group.

The fullerene derivative may be represented by Chemical Formula 1.

Chemical Formula 1 Cₓ(OH)_{y}

wherein, x is 60, 70, 74, 76, or 78 and y is an integer from 12 to 44.

An average particle diameter of the fullerene derivative may be less than about 10 nm.

The compound having at least one positively-charged functional group may have a LUMO energy level of greater than or equal to about 4.3 eV and less than or equal to about 5.3 eV.

The positively-charged functional group may include a nitrogen-containing functional group.

The nitrogen-containing functional group may include at least one of an amino group, a nitro group, a secondary amine group, a tertiary amine group, a quaternary ammonium group, a diamine group, a polyamine group, an azo group, an amide group, or a nitrogen-containing heterocyclic group.

The at least one compound having the positively-charged functional group may further include an oxygen-containing functional group, and an atomic ratio of nitrogen (N) relative to oxygen (O) in the compound may be greater than or equal to about 0.25.

The oxygen-containing functional group may include at least one of a hydroxy group, an ester group, a carbonyl group, or a carboxylic acid group.

The compound having the positively-charged functional group may have at least two positively-charged functional groups.

The compound having the positively-charged functional group may include leucine, lysine, methionine, valine, serine, cysteine, cystine, arginine, asparagine, aspartic acid, alanine, ornithine, isoleucine, threonine, tyrosine, glutamine, glutamic acid, glycine, histidine, phenylalanine, proline, urea, betaine, or a combination thereof.

The at least one compound having the positively-charged functional group may include a first compound including one positively-charged functional group and a second compound including two or more positively-charged functional groups.

The first compound may include at least one of leucine, methionine, valine, serine, cysteine, aspartic acid, alanine, isoleucine, threonine, tyrosine, glutamic acid, glycine, phenylalanine, proline, betaine, or a combination thereof, and the second compound may include at least one of lysine, cystine, arginine, asparagine, ornithine, glutamine, histidine, urea, or a combination thereof.

The first compound and the second compound may be included in a weight ratio of about 1:3 to about 10:1.

The at least one compound having the positively-charged functional group may have a positive charge in water.

The fullerene derivative may be included in an amount of about 0.001 weight percent (wt%) to about 5 wt% based on a total weight the polishing slurry, and the compound having the positively-charged functional group may be included in an amount of about 0.001 wt% to about 1 wt% based on a total weight of the polishing slurry.

The polishing slurry may have pH of about 1.0 to about 7.0.

The polishing slurry may further include an oxidizing agent, a chelating agent, a surfactant, a dispersing agent, an acidity regulator, a solvent, or a combination thereof.

According to another embodiment, a method of manufacturing a semiconductor device includes positioning a semiconductor structure having a surface, wherein the surface and a polishing pad face each other, supplying the polishing slurry between the surface of the semiconductor structure and the polishing pad, and contacting the surface of the semiconductor structure with the polishing pad to polish the surface with the polishing slurry.

The semiconductor structure may include a metal wire. The method may include polishing the metal wire with the polishing slurry.

The metal wire may include tungsten.

A ratio of a polishing rate of tungsten to an etching rate of tungsten may be greater than or equal to about 2.

Polishing performance may be improved while reducing damage and shape deformation of fine pitch structures.

### BRIEF DESCRIPTION OF THE DRAWINGS

FIGS. 1 to 4 are cross-sectional views showing a method of manufacturing a semiconductor device according to an embodiment.
FIG. 1 represents an insulation layer on a substrate with trenches formed in the insulation layer, and a conductive layer formed on the walls and floor of the trenches;
FIG. 2 represents a metal layer of an embodiment formed on the conductive layer and fills the trenches of FIG. 1;
FIG. 3 represents a metal structure of an embodiment that is planarized to coincide with a surface of the insulation layer; and
FIG. 4 represents a metal structure of an embodiment with a capping layer.

### DETAILED DESCRIPTION OF THE EMBODIMENTS

Example embodiments will hereinafter be described in detail, and may be easily performed by a person having an ordinary skill in the related art. However, this disclosure may be embodied in many different forms and is not to be construed as limited to the example embodiments set forth herein. Rather, these embodiments are provided so that this disclosure will be thorough and complete, and will fully convey the scope of the invention to those skilled in the art.

In the drawings, the thickness of layers, films, panels, regions, etc., are exaggerated for clarity. Like reference numerals designate like elements throughout the specification. It will be understood that when an element such as a layer, film, region, or substrate is referred to as being "on" another element, it can be directly on the other element or intervening elements may also be present. In contrast, when an element is referred to as being "directly on" another element, there are no intervening elements present.

The terminology used herein is for the purpose of describing particular embodiments only and is not intended to be limiting. As used herein, the singular forms "a," "an," and "the" are intended to include the plural forms, including "at least one," unless the content clearly indicates otherwise. "At least one" is not to be construed as limiting "a" or "an." "Or" means "and/or." As used herein, the term "and/or" includes any and all combinations of one or more of the associated listed items. It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

It will be understood that, although the terms "first," "second," "third" etc. may be used herein to describe various compounds, components, regions, layers and/or sections, these compounds, components, regions, layers and/or sections should not be limited by these terms. These terms are only used to distinguish one compound, component, region, layer or section from another compound, component, region, layer, or section.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within ± 10% or 5% of the stated value.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

Exemplary embodiments are described herein with reference to cross section illustrations that are schematic illustrations of idealized embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

Hereinafter, a polishing slurry according to an embodiment is described.

The polishing slurry according to an embodiment may include a fullerene derivative and at least one compound having at least one positively-charged functional group.

A fullerene derivative is a fullerene that has been surface-functionalized, for example, with a hydrophilic group. The fullerene derivative may have a fullerene core and at least one functional group bound to the fullerene core. The fullerene core may generally be hydrophobic, and may be C60, C70, C74, C76, or C78, but is not limited thereto.

The functional group bound to the fullerene core may be for example a negatively-charged functional group, for example at least one of a hydroxy group, a carbonyl group, a carboxylate group, a sulfonate group, a sulfate group, a sulfhydryl group, or a phosphate group, but is not limited thereto. For example, the negatively-charged functional group may be a hydroxy group. The term "negatively charged" refers to a functional group with a localized anionic charge, or a functional group with lone electron pairs on oxygen.

The fullerene derivative may be a fullerene with a hydrophilic functional group. The hydrophilic functional group may include for example at least one of a hydroxyl group, a carbonyl group, a carboxyl group, a sulfhydryl group, or a phosphate group, but is not limited thereto. For example, the hydrophilic functional group may be a hydroxyl group.

The fullerene derivative may have one or more negatively-charged functional groups in average, for example 1 or more and less than or equal to 44 negatively-charged functional groups in average, 2 or more and less than or equal to 44 negatively-charged functional groups in average, 3 or more and less than or equal to 44 negatively-charged functional groups in average, 5 or more and less than or equal to 44 negatively-charged functional groups in average, 8 or more and less than or equal to 44 negatively-charged functional groups in average, 10 or more and less than or equal to 44 negatively-charged functional groups in average, 12 or more and less than or equal to 44 negatively-charged functional groups in average, 16 or more and less than or equal to 44 negatively-charged functional groups in average, 20 or more and less than or equal to 44 negatively-charged functional groups in average, 24 or more and less than or equal to 44 negatively-charged functional groups in average, 24 to 40 negatively-charged functional groups in average, 24 to 36 negatively-charged functional groups in average, 28 to 44 negatively-charged functional groups in average, 28 to 40 negatively-charged functional groups in average, 30 to 38 negatively-charged functional groups in average, or 30 to 34 negatively-charged functional groups in average, per the fullerene core.

Herein, the average number of negatively-charged functional groups of the negatively-charged fullerene derivative may be confirmed by elemental analysis, thermogravimetric analysis, spectroscopic analysis, mass spectrometry, and the like. For example, it may be an average value of the highest two peaks in the liquid chromatography mass spectrum (LC-MS).

For example, the fullerene derivative may be a hydroxyl fullerene represented by Chemical Formula 1.

Chemical Formula 1 Cₓ(OH)_{y}

wherein, x is 60, 70, 74, 76, or 78 and y is an integer from 2 to 44.

Herein, the average number of hydroxy groups of the hydroxyl fullerene may be confirmed by elemental analysis, thermogravimetric analysis, spectroscopic analysis, mass spectrometry, and the like. For example, it may be an average value of the highest two peaks in the liquid chromatography mass spectrum (LC-MS).

For example, the fullerene derivative may be hydroxyl fullerene represented by Cₓ(OH)_{y} (wherein, x may be 60, 70, 74, 76, or 78 and y may be an integer from 12 to 44).

For example, the fullerene derivative may be hydroxyl fullerene represented by Cₓ(OH)_{y} (wherein, x may be 60, 70, 74, 76, or 78 and y may be an integer from 24 to 44).

For example, the fullerene derivative may be hydroxyl fullerene represented by Cₓ(OH)_{y} (wherein, x may be 60, 70, 74, 76, or 78 and y may be an integer from 32 to 44).

The fullerene derivative may have a negative charge in water.

The fullerene derivative may effectively function as an abrasive in a polishing slurry. The fullerene derivative may have a relatively small size, e.g., a diameter, of less than about 10 nanometers (nm) unlike a conventional abrasive such as silica having a particle diameter of tens to hundreds of nanometers. The fullerene derivative may be effectively applied to fine pitch structures, e.g. a fine pitch structure of a semiconductor structure having a width of less than or equal to about 10 nm.

In addition, the negatively-charged functional groups bound to the fullerene core may further impart chemical polishing properties and reduce damage and morphological deformation, such as scratches, dishing, and/or erosion, to the structure to be polished.

For example, the fullerene derivative may be a fine particle having an average particle diameter of less than about 10 nanometers (nm), within the range, less than about 8 nm, less than about 7 nm, less than about 5 nm, less than about 3 nm, less than about 2 nm, or less than about 1 nm, for example greater than or equal to about 0.01 nm and less than about 10 nm, greater than or equal to about 0.01 nm and less than about 8 nm, greater than or equal to about 0.01 nm and less than about 7 nm, greater than or equal to about 0.01 nm and less than about 5 nm, greater than or equal to about 0.01 nm and less than 3 nm, greater than or equal to about 0.01 nm and less than about 2 nm, or greater than or equal to about 0.01 nm and less than about 1 nm. Herein, an average particle diameter of the fullerene derivative may be measured by Multi-angle dynamic light scattering (MADLS).

The fullerene derivative may be included in an amount of about 0.001 weight percent (wt%) to about 5 wt% based on a total amount of the polishing slurry (including a solvent). Within the range, the fullerene derivative may be included in an amount of about 0.001 wt% to about 3 wt%, about 0.001 wt% to about 2 wt%, about 0.001 wt% to about 1 wt%, about 0.001 wt% to about 0.8 wt%, about 0.001 wt% to about 0.5 wt%, about 0.005 wt % to about 0.4 wt%, about 0.01 wt% to about 0.3 wt%, about 0.015 wt% to about 0.3 wt%, or about 0.02 wt% to about 0.2 wt%.

The at least one compound having a positively-charged functional group may include at least one positively-charged functional group in the molecule. The compound having the positively-charged functional group may have for example at least two positively-charged functional groups, for example at least three positively-charged functional groups, or at least four positively-charged functional groups, but is not limited thereto. The compound having the positively-charged functional group may have for example 1 to 7 positively-charged functional groups, and within the range, 2 to 7, 3 to 7, or 4 to 7 positively-charged functional groups.

For example, the lowest unoccupied molecular orbital (LUMO) energy level of the compound having the positively-charged functional group and a work function of the polished metal may have a small difference. For example, a difference between the LUMO energy level of the compound having the positively-charged functional group and the work function of the polished metal (e.g., an absolute value of the difference) may be less than or equal to about 1.0 electron Volts (eV), within the range, less than or equal to about 0.9 eV, less than or equal to about 0.8 eV, less than or equal to about 0.7 eV, less than or equal to about 0.6 eV, less than or equal to about 0.5 eV, less than or equal to about 0.4 eV, less than or equal to about 0.3 eV, less than or equal to about 0.2 eV, for example greater than or equal to about 0.1 eV and less than or equal to about 1.0 eV, greater than or equal to about 0.1 eV and less than or equal to about 0.9 eV, greater than or equal to about 0.1 eV and less than or equal to about 0.8 eV, greater than or equal to about 0.1 eV and less than or equal to about 0.7 eV, greater than or equal to about 0.1 eV and less than or equal to about 0.6 eV, greater than or equal to about 0.1 eV and less than or equal to about 0.5 eV, greater than or equal to about 0.1 eV and less than or equal to about 0.4 eV, greater than or equal to about 0.1 eV and less than or equal to about 0.3 eV, or greater than or equal to about 0.1 eV and less than or equal to about 0.2 eV.

For example, a LUMO energy level of the compound having the positively-charged functional group may be less than or equal to about 5.3 eV, within the range, less than or equal to about 5.2 eV, less than or equal to about 5.1 eV, less than or equal to about 5.0 eV, less than or equal to about 4.9 eV, less than or equal to about 4.8 eV, less than or equal to about 4.7 eV, less than or equal to about 4.6 eV, less than or equal to about 4.5 eV, or less than or equal to about 4.4 eV, and for example greater than or equal to about 4.3 eV and less than or equal to about 5.3 eV, greater than or equal to about 4.3 eV and less than or equal to about 5.2 eV, greater than or equal to about 4.3 eV and less than or equal to about 5.1 eV, greater than or equal to about 4.3 eV and less than or equal to about 5.0 eV, greater than or equal to about 4.4 eV and less than or equal to about 5.0 eV, greater than or equal to about 4.5 eV and less than or equal to about 5.0 eV, greater than or equal to about 4.5 eV and less than or equal to about 4.9 eV, greater than or equal to about 4.5 eV and less than or equal to about 4.8 eV, or greater than or equal to about 4.6 eV and less than or equal to about 4.8 eV.

Although not wishing to be bound by any theory, the compound having the positively charged functional group having the LUMO energy level as described above has a small energy difference from the work function of the polished metal such as tungsten or copper, and thus electrons generated during a polishing process, for example, an oxidation process of the metal to be polished may be easily transferred to the compound having the positively charged functional group. Therefore, electron mobility may be improved by lowering an energy barrier for electrons generated from the polished metal to move, and thereby increasing a material removal rate (MRR) of the polished metal due to easy generation of oxides of the polished metal.

For example, the positively-charged functional group may include a nitrogen-containing functional group, for example at least one of an amino group, a nitro group, secondary amine group, a tertiary amine group, a quaternary ammonium group, diamine group, a polyamine group, an azo group, an amide group, and a nitrogen-containing heterocyclic group, but is not limited thereto. In one example, the nitrogen containing functional group may be an amino group. For example, the compound having the positively charged functional group may be a compound having a positive charge in water.

For example, the at least one compound having the positively charged functional group may further include an oxygen-containing functional group in the compound, and may include, for example, at least one of a hydroxy group, an ester group, a carbonyl group, or a carboxylic acid group, but is not limited thereto.

For example, an atomic ratio of nitrogen (N) relative to oxygen (O) included in the compound having the positively charged functional group may be greater than or equal to about 0.25. Within the range, it may be greater than or equal to about 0.3, greater than or equal to about 0.4, greater than or equal to about 0.5, greater than or equal to about 0.6, greater than or equal to about 0.67, greater than or equal to about 0.7, greater than or equal to about 0.8, greater than or equal to about 0.9, greater than or equal to about 1.0, greater than or equal to about 1.2, greater than or equal to about 1.5, greater than or equal to about 2.0, or greater than or equal to about 2.5, for example, greater than or equal to about 0.25 and less than or equal to about 2.5, greater than or equal to about 0.3 and less than or equal to about 2.0, greater than or equal to about 0.5 and less than or equal to about 2.0, greater than or equal to about 0.6 and less than or equal to about 2.0, greater than or equal to about 1.0 and less than or equal to about 2.0, or greater than or equal to about 1.5 and less than or equal to about 2.0. The higher the atomic ratio of nitrogen (N) relative to oxygen (O) included in the compound, the more preferentially it may be adsorbed on the surface of the metal by electrostatic attraction when polishing a metal, such as tungsten, which generally has a negative surface charge, and resulting in improved performance in reducing or preventing over-etching of the metal surface.

For example, the at least one compound having the positively charged functional group may be leucine, lysine, methionine, valine, serine, cysteine, cystine, arginine, asparagine, aspartic acid, alanine, ornithine, isoleucine, threonine, tyrosine, glutamine, glutamic acid, glycine, histidine, phenylalanine, proline, urea, betaine, derivatives thereof, or a combination thereof, but is not limited thereto. For example, the lysine may be L-lysine, D-lysine or DL-lysine, and the arginine may be L-arginine, D-arginine, or DL-arginine, but are not limited thereto.

The at least one compound having the positively charged functional group may have positive charges in water, and thus the compound having the positively charged functional group may exhibit charge characteristics opposite to that of the negatively-charged fullerene derivative in water. Accordingly, when polishing a metal, such as tungsten, which generally has a negative surface charge, the compound having the positively charged functional group may be preferentially adsorbed to the surface of the metal over the fullerene derivative by electrostatic attraction.

The compound having the positively-charged functional group is preferentially adsorbed on the surface of the metal, and may function as a reaction inhibitor to reduce or prevent over-etching of the metal surface by unwanted chemical reactions during and/or after the chemical mechanical polishing process.

For example, during the polishing process using the fullerene derivative, one can reduce or minimize the degree of over-etching caused by high etching rates of the metal. Moreover, after the polishing process, it is possible to prevent excessive etching of the metal surface by undesired continuous chemical reaction of fine abrasive particles. Therefore, by including the compound having the positively charged functional group in the polishing slurry, it is possible to reduce the etching rate of metal wire or the like in the polishing process. The etching rate may be a measure of the chemical conversion level of the polishing slurry, and higher etch rates may indicate faster etching of the associated metal surface.

For example, the polishing slurry may include two or more types of compounds having positively-charged functional groups, for example, two or more types of compounds having different numbers of positively-charged functional groups. For example, it may include a first compound including one positively-charged functional group and a second compound including two or more positively-charged functional groups.

The first compound may include at least one of leucine, methionine, valine, serine, cysteine, aspartic acid, alanine, isoleucine, threonine, tyrosine, glutamic acid, glycine, phenylalanine, proline, betaine, a derivative thereof, or a combination thereof, but is not limited to thereto.

The second compound may include, but is not limited to, at least one of lysine, cystine, asparagine, ornithine, glutamine, histidine, urea, a derivative thereof, or a combination thereof.

For example, the first compound and the second compound may be included in a weight ratio of about 1:3 to about 10:1, within the range about 1:3 to about 9:1, or about 1:3 to about 8:1, or about 1:3 to about 7:1, or about 1:3 to about 5:1, or about 1:3 to about 3:1, or about 1:1 to about 10:1, or about 1:1.2 to about 10:1, or about 1:1.4 to about 10:1, or about 1:1.6 to about 10:1, or about 1:1.8 to about 10:1, or about 1:2 to about 10:1.

The compound having the positively-charged functional group may be included in an amount of about 0.001 wt% to about 1 wt% based on a total amount of the polishing slurry (including a solvent). Within the range, the compound having the positively-charged functional group may be included in an amount of about 0.001 wt% to about 0.8 wt%, about 0.001 wt% to about 0.6 wt%, about 0.001 wt% to about 0.4 wt%, about 0.001 wt% to about 0.2 wt%, about 0.001 wt% to about 0.1 wt%, about 0.001 wt% to about 0.05 wt%, about 0.01 wt% to about 0.05 wt%, about 0.02 wt% to about 0.08 wt%, or about 0.03 wt% to about 0.1 wt%.

The pH of the polishing slurry may be achieved or maintained by any suitable methods, considering polishing rate, dispersion stability, and the like. For example, the pH of the polishing slurry may be for example about 1.0 to about 7.0, within the range about 1.0 to about 5.0, about 1.0 to about 4.0, about 1.0 to about 3.0, about 1.0 to about 2.5, about 1.2 to about 2.5, about 1.5 to about 2.5, about 1.5 to about 2.0, or about 1.5 to about 1.8.

The polishing slurry may further include an additive and the additive may include for example an oxidizing agent, a chelating agent, a surfactant, a dispersing agent, an acidity regulator, a solvent, or a combination thereof, but is not limited thereto.

The oxidizing agent may be added to the polishing slurry during or immediately before the polishing process, such as a hydrogen peroxide solution, periodic acid, potassium iodide, potassium permanganate, ammonium sulfate, ammonium molybdate, iron nitrate, nitric acid, potassium nitrate, sodium hydroxide, potassium hydroxide, or a combination thereof, but is not limited thereto.

The oxidizing agent may be included in an amount of about 0.1 wt% to about 10 wt% based on a total amount of the polishing slurry (including a solvent). Within the range, the oxidizing agent may be included in an amount of about 0.1 wt% to about 8 wt%, about 0.1 wt% to about 6 wt%, about 0.1 wt% to about 4 wt%, about 0.1 wt% to about 3 wt%, about 0.1 wt% to about 2 wt%, or about 0.1 wt% to about 1 wt%.

The chelating agent may be, for example, phosphoric acid, nitric acid, citric acid, malonic acid, salts thereof, or a combination thereof, but is not limited thereto.

The chelating agent may be included in an amount of about 0.002 wt% to about 20 wt% based on a total amount of the polishing slurry (including a solvent). Within the range, the chelating agent may be included in an amount of about 0.002 wt% to about 10 wt%, about 0.002 wt% to about 5 wt%, about 0.002 wt% to about 1 wt%, about 0.002 wt% to about 0.5 wt%, about 0.002 wt% to about 0.1 wt%, about 0.002 wt% to about 0.07 wt%, about 0.002 wt% to about 0.04 wt%, or about 0.002 wt% to about 0.02 wt%.

The surfactant may be an ionic or non-ionic surfactant, and may be, for example, a copolymer of ethylene oxide, a copolymer of propylene oxide, an amine compound, or a combination thereof, but is not limited thereto.

The dispersing agent may promote dispersion of the carbon abrasive particles, and may include, for example, a water-soluble monomer, a water-soluble oligomer, a water-soluble polymer, a metal salt, or a combination thereof. A weight average molecular weight of the water-soluble polymer may be less than or equal to about 10,000 grams per mole (g/mole), for example, less than or equal to about 5,000 g/mole, or less than or equal to about 3,000 g/mole. The metal salt may be for example a copper salt, a nickel salt, a cobalt salt, a manganese salt, a tantalum salt, a ruthenium salt, or a combination thereof. The dispersing agent may include, for example, poly(meth)acrylic acid, poly(meth)acryl maleic acid, polyacrylonitrile-co-butadiene-acrylic acid, carboxylic acid, sulfonic ester, sulfonic acid, phosphoric ester, cellulose, diol, a salt thereof or a combination thereof, but is not limited thereto.

The acidity regulator may adjust the pH of the polishing slurry, and may be, for example, an inorganic acid, an organic acid, salts thereof, or a combination thereof. The inorganic acids may include, for example, nitric acid, hydrochloric acid, phosphoric acid, sulfuric acid, hydrofluoric acid, bromic acid, iodic acid, or a salt thereof, and the organic acid may be, for example, formic acid, malonic acid, malic acid, maleic acid, oxalic acid, adipic acid, citric acid, acetic acid, propionic acid, , fumaric acid, lactic acid, salicylic acid, benzoic acid, succinic acid, phthalic acid, butyric acid, glycolic acid, tartaric acid, or a salt thereof, but are not limited thereto.

Each additive may be included independently, for example, in a trace amount of about 1 part per million (ppm) to about 100,000 ppm based on the total weight of the polishing slurry, but is not limited thereto.

The polishing slurry may further include a solvent capable of dissolving or dispersing the aforementioned components. The solvent may be a polar solvent, for example, and may be water, alcohol (e.g., ethanol), acetic acid, acetone, or a mixture thereof. In one example, the solvent may be water, for example distilled water, deionized water, ion exchanged water and/or ultrapure water.

The polishing slurry may be used for providing polished surfaces of various semiconductor structures, for example, it may be applied for a polishing process of a conductor such as a metal wire or a polishing process of an insulator such as an insulation layer or a shallow trench isolation (STI). For example, the polishing slurry may be used to polish a conductive layer, an insulating layer, and/or a semiconductor layer having a charged surface in a semiconductor substrate. The polishing slurry may be used effectively to polish a conductive layer, an insulating layer, and a semiconductor layer which generally have negatively-charged surfaces.

For example, the polishing slurry may be used to polish a conductor such as a metal wire in a semiconductor structure and may be used to polish a conductor such as copper (Cu), tungsten (W), or an alloy thereof.

Hereinafter, an example of a method of manufacturing a semiconductor device using the aforementioned polishing slurry is described.

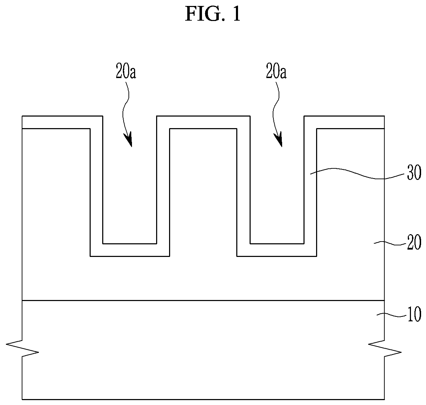

FIGS. 1 to 4 are cross-sectional views showing a method of manufacturing a semiconductor device according to an embodiment.

Referring to FIG. 1, an interlayer insulating layer 20 is formed on the semiconductor substrate 10. The interlayer insulating layer 20 may include an oxide, a nitride, and/or an oxynitride. Subsequently, the interlayer insulating layer 20 is etched to provide a trench 20a. The trench 20a may have a width of less than or equal to about 10 nm. Subsequently, a barrier layer 30 is formed on the wall surface of the trench. The barrier layer 30 may include, for example, Ta and/or TaN, but is not limited thereto.

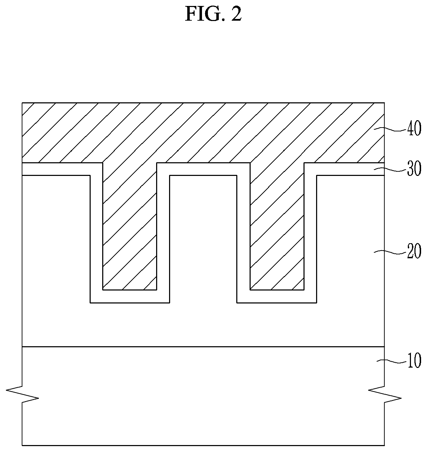

Referring to FIG. 2, a metal such as copper (Cu) is deposited and fills the inside of the trench to provide a metal layer 40.

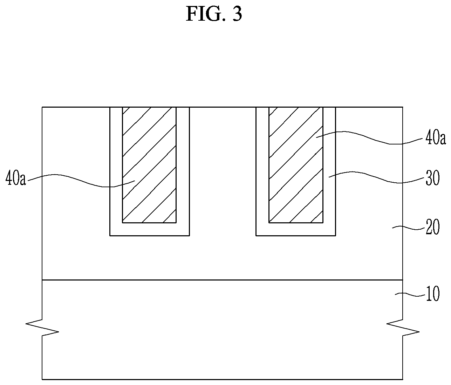

Referring to FIG. 3, a surface of the metal layer 40 is planarized to match the surface of the interlayer insulating layer 20 and forms a filled metal layer 40a. The planarization may be performed by chemical mechanical polishing using a chemical mechanical polishing (CMP) equipment, and may use the above-described polishing slurry, which will be described later. For example, when the barrier layer 30 is a Ta layer and the metal layer 40 is a Cu layer, the polishing selectivity of Ta to Cu of the polishing slurry is relatively high, for example, the polishing selectivity of Ta to Cu is greater than about 50:1.

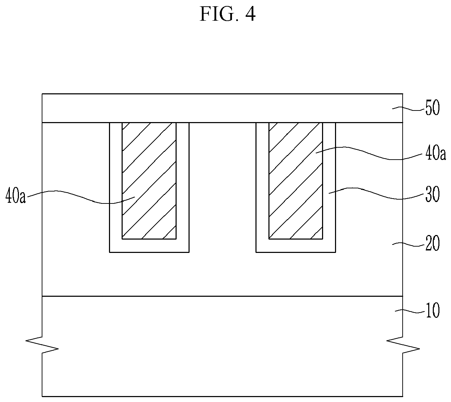

Referring to FIG. 4, a capping layer 50 is formed on the filled metal layer 40 and the interlayer insulating layer 20. The capping layer 50 may include SiN and/or SiC, but is not limited thereto.

Hereinafter, a method of planarization for forming the filled metal layer 40a is described. The planarization may be performed by chemical mechanical polishing using chemical mechanical polishing (CMP) equipment and the polishing slurry described. The chemical mechanical polishing equipment may include for example a lower base; a platen rotatable on the lower base; a polishing pad disposed on the platen; a pad conditioner; and at least one polishing slurry supplying equipment disposed adjacent to the polishing pad and supplying the polishing pad with the polishing slurry.

The platen may be rotated on a surface of the lower base. For example, the platen may be supplied with a rotation power from a motor disposed in the lower base. Accordingly, the platen may be rotated with a center of an imaginary rotating axis perpendicular to the surface of the platen. The imaginary rotating axis may be perpendicular to the surface of the lower base.

The platen may be equipped with at least one supply line through which liquid is injected and discharged. Water may be injected and discharged through the supply line inside the platen to adjust a temperature of the platen. For example, cooling water may be injected and discharged through the supply line inside the platen and thus lower the temperature of the platen. For example, hot water at a high temperature may be injected and discharged through the supply line inside the platen and thus raise the temperature of the platen.

The polishing pad may be disposed on the surface of the platen so that it may be supported by the platen. The polishing pad may be rotated together with the platen. The polishing pad may have a rough polishing surface. This polishing surface may directly contact the semiconductor substrate 10 and thus mechanically polish a surface of the semiconductor substrate 10. The polishing pad may be a porous material having a plurality of micropores which may hold the polishing slurry.

The pad conditioner may be disposed adjacent to the polishing pad and maintain a polishing surface so that the surface of the semiconductor substrate 10 may be effectively polished.

The polishing slurry supplying equipment may be disposed adjacent to the polishing pad to supply the polishing pad with the polishing slurry. The polishing slurry supplying equipment may include a nozzle to supply the polishing slurry on the polishing pad, and a voltage supplying unit to apply a predetermined voltage to the nozzle. The polishing slurry in the nozzle is charged by a voltage applied by the voltage supplying unit, which is then discharged toward the polishing pad. The polishing slurry supplying equipment may supply the aforementioned polishing slurry.

The chemical mechanical polishing may be for example performed by positioning the semiconductor structure with substrate 10 and a surface that faces a polishing pad, supplying the polishing slurry, which is stored in the polishing slurry supplying equipment, between the surface of the semiconductor structure and the polishing pad, and contacting the surface of the semiconductor structure with the polishing pad to polish the surface with the polishing slurry.

For example, the polishing slurry may be used to polish a conductor such as a metal wire in a semiconductor structure, and may be used to polish a conductor such as copper (Cu), tungsten (W), or an alloy thereof, but is not limited thereto.

For example, the supplying of the polishing slurry may be performed for example at a rate of about 10 milliliters per minute (ml/min) to about 100 ml/min, for example at a flow rate of about 2 microliters to about 10 microliters.

The polishing may be performed by contacting a surface of the semiconductor structure with the polishing pad and rotating them to produce a mechanical friction. For example, a pressure of about 1 pound per square inch (psi) to about 5 psi may be applied during the polishing step.

For example, if the metal layer 40 and the filled metal layer 40a include tungsten, a ratio of the material removal rate (MRR) of tungsten relative to the etching rate (ER) of tungsten by the polishing slurry may be relatively high. The ratio of material removal rate (MRR) of tungsten relative to the etching rate (ER) may be for example greater than or equal to about 1, greater than or equal to about 2, greater than or equal to about 3, greater than or equal to about 4, greater than or equal to about 5, greater than or equal to about 6, greater than or equal to about 7, greater than or equal to about 8, greater than or equal to about 9, greater than or equal to about 10, greater than or equal to about 11, greater than or equal to about 12, greater than or equal to about 13, greater than or equal to about 14, greater than or equal to about 15, greater than or equal to about 16, greater than or equal to about 17, greater than or equal to about 18, greater than or equal to about 19, or greater than or equal to about 20, or within the range, about 1 to about 20, about 2 to about 20, about 3 to about 20, about 3 to about 19, about 3 to about 18, or about 3 to about 17.

Due to the aforementioned ratio of the polishing rate relative to the etching rate, the etching rate of the metal wire may be reduced, ensuring the flatness of the semiconductor line structure following the polishing process, as well as minimizing the undesired recesses in the line structure.

Hereinafter, the embodiments are illustrated in more detail with reference to examples. However, these examples are exemplary, and the scope of claims is not limited thereto.

### Synthesis Example: Synthesis of Hydroxyl Fullerene

A bead mill vessel having a height of about 100 millimeters (mm) and a diameter of about 50 mm is filled with beads to about 1/3 volume, and then, 1 gram (g) of fullerene (C60, Nanom purple ST, Frontier Carbon Corp.), 0.5 grams per Liter (g/L) of a dispersing agent (polyacrylic acid, Mw 1800, Merck & Co., Inc.), and 100 g of water are added to the mill. The beads are a mixture of 50 g of zirconia beads having an average particle diameter of 500 micrometers (µm), 50 g of zirconia beads having an average particle diameter of 5 mm, and 50 g of zirconia beads having average particle diameters of 10 mm.

Subsequently, after rotating the vessel for 40 hours, a sample of fullerene particles is removed from the mill, and the sample measured for average particle diameter. The particle diameter is measured using a dynamic light scattering-type Zeta-potential & particle size analyzer, ELS-Z (Otsuka Electronics Co., Ltd.). The mill is rotated until a sample of milled fullerene particles have an average particle diameter of less than or equal to 100 nm. After the desired average particle diameter is achieved the beads are removed from the mill, and 100 g of a 30 wt% hydrogen peroxide solution is added to the fullerene particle mixture. The fullerene particle mixture is then stirred at about 70 °C for 8 days to prepare a hydroxyl fullerene dispersion.

A particle diameter of the hydroxyl fullerene is measured by using the dynamic light scattering-type Zeta-potential & particle size analyzer (ELS-Z). The average number of the hydroxy group of the hydroxyl fullerene is evaluated by calculating an average of two highest peaks in a mass spectrum of the hydroxyl fullerene in a Fourier transform infrared spectroscopy (FTIR) method. The resulting hydroxyl fullerene (or fullerene derivative) are confirmed and best represented as C₆₀(OH)₃₆ having an average particle diameter of 2.5 nm and an average number of hydroxy group of 36 is obtained.

### Preparation Examples

### Preparation Example 1

An aqueous mixture (polishing slurry) is prepared including 0.1 wt% of the hydroxyl fullerene represented by C₆₀(OH)₃₆ according to synthesis example, 2.4 wt% of 30% hydrogen peroxide solution, 0.04 wt% of malic acid, 0.0031 wt% of iron nitrate, and 0.1 wt% of L-arginine (N/O=2.0) in water and the mixture is mixed, and nitric acid is added to the mixture to adjust the pH to be 1.8, to provide about 100 g of polishing slurry. The LUMO energy level is measured using X-ray photoelectron spectroscopy (XPS, Quantum 2000, PHI, Inc.) and N/O is an atomic ratio of nitrogen (N) relative to oxygen (O) included in the compound.

### Preparation Example 2

A polishing slurry is prepared in the same manner as in Preparation Example 1, except that 0.2 wt% of hydroxyl fullerene is used instead of 0.1 wt% of hydroxyl fullerene.

### Preparation Example 3

A polishing slurry is prepared in the same manner as in Preparation Example 1, except that 0.02 wt% of hydroxyl fullerene is used instead of 0.1 wt% of hydroxyl fullerene and 0.03 wt% of L-arginine is used.

### Preparation Example 4

A polishing slurry is prepared in the same manner as in Preparation Example 1, except that 0.02 wt% of hydroxyl fullerene is used instead of 0.1 wt% of hydroxyl fullerene.

### Preparation Example 5

A polishing slurry is prepared in the same manner as in Preparation Example 1, except that 0.02 wt% of hydroxyl fullerene is used instead of 0.1 wt% of hydroxyl fullerene and glycine (LUMO: 4.83 eV, N/O = 0.5) and L-arginine are mixed in a weight ratio of 7: 1 to be included in an amount of 0.1 wt% instead of 0.1 wt% of L-arginine.

### Preparation Example 6

A polishing slurry is prepared in the same manner as in Preparation Example 5, except that lysine (LUMO: 4.93 eV, N/O = 1.0) is used instead of L-arginine.

### Preparation Example 7

A polishing slurry is prepared in the same manner as in Preparation Example 5, except that glycine and glutamine (LUMO: 4.90 eV, N/O=0.67) are mixed in a weight ratio of 1:1.4 to be included in an amount of 0.1 wt% instead of glycine and L-arginine.

### Preparation Example 8

A polishing slurry is prepared in the same manner as in Preparation Example 7, except that glutamic acid (LUMO: 4.48 eV, N/O=0.25) is used instead of glutamine.

### Preparation Example 9

A polishing slurry is prepared in the same manner as in Preparation Example 1, except that lysine is used instead of L-arginine.

### Preparation Example 10

A polishing slurry is prepared in the same manner as in Preparation Example 1, except that cysteine (LUMO: 5.23 eV, N/O=0.5) is used instead of L-arginine.

### Preparation Example 11

A polishing slurry is prepared in the same manner as in Preparation Example 1, except that glycine is used instead of L-arginine.

### Comparative Preparation Example 1

A polishing slurry is prepared in the same manner as in Preparation Example 1, except that L-arginine is not included. The Preparation Examples are summarized in-weight percent of fullerene derivative and weight percent of amino acid or a mixture of amino acids with listed weight ratio in Table 1. The amounts of 2.4 wt% of 30% hydrogen peroxide solution, 0.04 wt% of malic acid, and 0.0031 wt% of iron nitrate are not listed in Table 1.

**Table 1 Polishing Slurries**

| | Fullerene C₆₀(OH)₃₆ (wt%) | Amino acid(s) (wt%) |
|---|---|---|
| Prep. Ex. 1 | 0.1 | 0.1 L-arginine |
| Prep. Ex. 2 | 0.2 | 0.1 L-arginine |
| Prep. Ex. 3 | 0.02 | 0.03 L-arginine |
| Prep. Ex. 4 | 0.02 | 0.1 L-arginine |
| Prep. Ex. 5 | 0.02 | 0.1, 7:1 ratio glycine:L-arginine |
| Prep. Ex. 6 | 0.02 | 0.1, 7:1 ratio glycine:lysine |
| Prep. Ex. 7 | 0.02 | 0.1, 1:1.4 ratio glycine:glutamine |
| Prep. Ex. 8 | 0.02 | 0.1, 1:1.4 ratio glycine:glutamic acid |
| Prep. Ex. 9 | 0.1 | 0.1 lysine |
| Prep. Ex. 10 | 0.1 | 0.1 cysteine |
| Prep. Ex. 11 | 0.1 | 0.1 glycine |
| Comp. Ex. 1 | 0.1 | - |

Evaluation I

Material removal rates (MRR) and etching rates (ER) are evaluated by performing polishing under the following conditions.

Polishing equipment: MA-200e (Musashino Denshi Corp.)

Polished object:
(1) Wafer for measuring polishing rate: A 20 mm by 20 mm wafer having a 1.5 µm-thick tungsten (W) film formed on a silicon substrate is prepared.
(2) Specimen for measuring etching rate: A 20 mm x 20 mm tungsten (work function: 4.63 eV) pattern specimen is prepared. This specimen is composed of a tungsten line having a width of 0.20 micrometers (µm) and a silicon oxide spacer line having a width of 0.20 µm between the tungsten lines.
(3) Polishing pad: IC1000 (KPX Corp.)
(4) The rotation speed of polishing platen: 90 revolutions per minute (rpm)
(5) The rotation speed of polishing pad: 90 rpm
(6) A method of supplying polishing slurry: 200 ml of polishing slurry is put on the polishing pad and polishing is performed.
(7) Polishing pressure: 14 kilopascals (kPa)
(8) Polishing temperature: 25 °C

The MRR is determined by performing polishing for 5 minutes, converting electrical resistance measurements into thicknesses of the tungsten (W) film before and after the polishing, and using them for conversion into a rate. The ER is determined by performing polishing for 5 minutes, measuring the changed weight of the specimen before and after the polishing, and using them for conversion into an etching rate of tungsten.

The results are shown in Table 2.

**Table 2**

| | Polishing rate (nm/min) | Etching rate (nm/min) | Polishing ratio Polishing rate/Etching rate |
|---|---|---|---|
| Preparation Example 1 | 2.23 | 0.59 | 3.78 |
| Preparation Example 2 | 3.65 | 0.54 | 6.76 |
| Preparation Example 3 | 3.00 | 0.81 | 3.45 |
| Preparation Example 4 | 4.00 | 0.21 | 16.70 |
| Preparation Example 5 | 5.09 | 0.74 | 6.88 |
| Preparation Example 6 | 7.1 | 2.11 | 3.36 |
| Preparation Example 7 | 6.69 | 2.24 | 2.99 |
| Preparation Example 8 | 7.55 | 2.43 | 3.11 |
| Preparation Example 9 | 3.7 | 1.02 | 3.62 |
| Preparation Example 10 | 8.4 | 2.47 | 3.40 |
| Preparation Example 11 | 16.7 | 5.41 | 3.09 |
| Comparative Preparation Example 1 | 6.9 | 18.7 | 0.37 |

Referring to Table 1, when polishing the tungsten (W) film using the polishing slurries according to the preparation examples, the etching rates are reduced compared to the polishing of tungsten with a polishing slurry according to the Comparative Example 1, and the ratio of the polishing rate relative to the etching rate is significantly greater for each preparation example. In addition, the polishing rate of a tungsten (W) film using the polishing slurry according to the preparation examples, each of which has a small difference in the LUMO energy level between the tungsten (W) and the compound having the positively-charged functional group included in the polishing slurry, are significantly greater than that of the Comparative Example 1.

While this disclosure has been described in connection with what is presently considered to be practical example embodiments, it is to be understood that the invention is not limited to the disclosed embodiments, but, on the contrary, is intended to cover various modifications and equivalent arrangements included within the scope of the appended claims.

Description of symbols
- 10:: semiconductor substrate
- 20:: interlayer insulating layer
- 20a:: trench
- 30:: barrier layer
- 40:: metal layer
- 40a:: filled metal layer
- 50:: capping layer

## Claims

1. A polishing slurry comprising
a fullerene derivative, and
at least one compound having at least one positively-charged functional group.

2. The polishing slurry of claim 1, wherein the fullerene derivative has at least one negatively-charged functional group;
preferably wherein the negatively-charged functional group comprises at least one of a hydroxy group, a carbonyl group, a carboxylate group, a sulfonate group, a sulfate group, a sulfhydryl group, or a phosphate group.

3. The polishing slurry of claims 1 or 2, wherein the fullerene derivative is represented by Chemical Formula 1:
Chemical Formula 1 Cₓ(OH)_{y}
wherein, x is 60, 70, 74, 76, or 78 and y is an integer from 12 to 44.

4. The polishing slurry of any of claims 1-3, wherein an average particle diameter of the fullerene derivative is less than 10 nanometers; and/or
wherein the at least one compound having at least one positively-charged functional group has a LUMO energy level of greater than or equal to 4.3 eV and less than or equal to 5.3 eV.

5. The polishing slurry of any of claims 1-4, wherein the at least one positively-charged functional group comprises a nitrogen-containing functional group;
preferably wherein the nitrogen-containing functional group comprises at least one of an amino group, a nitro group, a secondary amine group, a tertiary amine group, a quaternary ammonium group, a diamine group, a polyamine group, an azo group, an amide group, or a nitrogen-containing heterocyclic group.

6. The polishing slurry of claim 5, wherein
the at least one compound having the positively-charged functional group including the nitrogen-containing functional group further comprises an oxygen-containing functional group with an atomic ratio of nitrogen relative to oxygen in the compound is greater than or equal to 0.25;
preferably wherein the oxygen-containing functional group comprises at least one of a hydroxy group, an ester group, a carbonyl group, or a carboxylic acid group.

7. The polishing slurry of any of claims 1-6, wherein the at least one compound having the positively-charged functional group has at least two positively-charged functional groups; and/or
wherein the at least one compound having the positively-charged functional group comprises leucine, lysine, methionine, valine, serine, cysteine, cystine, arginine, asparagine, aspartic acid, alanine, ornithine, isoleucine, threonine, tyrosine, glutamine, glutamic acid, glycine, histidine, phenylalanine, proline, urea, betaine, or a combination thereof.

8. The polishing slurry of any of claims 1-7, wherein the at least one compound having the positively-charged functional group comprises a first compound comprising one positively-charged functional group and a second compound comprising two or more positively-charged functional groups.

9. The polishing slurry of claim 8, wherein
the first compound comprises at least one of leucine, methionine, valine, serine, cysteine, aspartic acid, alanine, isoleucine, threonine, tyrosine, glutamic acid, glycine, phenylalanine, proline, betaine, or a combination thereof, and
the second compound comprises at least one of lysine, cystine, arginine, asparagine, ornithine, glutamine, histidine, urea, or a combination thereof;
preferably wherein the first compound and the second compound are present in a weight ratio of 1:3 to 10:1.

10. The polishing slurry of any of claims 1-9, wherein the at least one compound having the positively-charged functional group has a positive charge in water.

11. The polishing slurry of any of claims 1-10, wherein
the fullerene derivative is included in an amount of 0.001 weight percent to 5 weight percent, and the compound having the positively-charged functional group is included in an amount of 0.001 weight percent to 1 weight percent, based on a total weight of the polishing slurry.

12. The polishing slurry of any of claims 1-11, wherein the polishing slurry has pH of 1.0 to 7.0; and/or
wherein the polishing slurry further comprises an oxidizing agent, a chelating agent, a surfactant, a dispersing agent, an acidity regulator, a solvent, or a combination thereof.

13. A method of manufacturing a semiconductor device, comprising
positioning a semiconductor structure having a surface, wherein the surface and a polishing pad face each other;
supplying the polishing slurry of any of claims 1-12 between the surface of the semiconductor structure and the polishing pad; and
contacting the surface of the semiconductor structure with the polishing pad to polish the surface with the polishing slurry.

14. The method of claim 13, wherein the semiconductor structure comprises a metal wire that is polished.

15. The method of claim 14, wherein the metal wire comprises tungsten;
preferably wherein a ratio of a polishing rate of tungsten to an etching rate of tungsten is greater than or equal to 2.
